# EUROPEAN PATENT APPLICATION

(11) **EP 4 647 837 A1**
(43) Date of publication of application: **12.11.2025**
(21) Application number: 24174481.2
(22) Date of filing: 07.05.2024
(51) Int. Cl.: G03F 7/00, G01N 21/956, H01L 21/66

(54) **METROLOGY METHOD AND ASSOCIATED APPARATUS**

(71) Applicant: ASML Netherlands B.V., 5500 AH Veldhoven (NL)
(72) Inventor: ALIAJ, Ilirjan, 5500 AH Veldhoven (NL); ANUNCIADO, Roy, 5500 AH Veldhoven (NL); NAYAK, Deepak, Ranjan, 5500 AH Veldhoven (NL)
(74) Representative: ASML Netherlands B.V.

(57) **Abstract**

Disclosed is a method of determining at least one vertical parameter of interest relating to a structure of interest on a substrate comprising: obtaining first metrology data and/or data derived therefrom, the first metrology data relating to a measurement of the structure of interest when not comprising a layer of interest to which the vertical parameter of interest relates, or a representative structure being representative of the structure of interest when not comprising the layer of interest; obtaining second metrology data relating to a measurement of the structure of interest when comprising the layer of interest; removing the first metrology data and/or data derived therefrom from the second metrology data to obtain residual metrology data; obtaining at least one model to relate the residual metrology data to the vertical parameter of interest; and using the model to derive the vertical parameter of interest from the residual metrology data.

## Description

### FIELD

0001 The present invention relates to a metrology apparatus and methods usable, for example, to perform metrology in the manufacture of devices by lithographic techniques. The invention further relates to such methods for determining a vertical parameter of interest in a lithographic process.

### BACKGROUND

0002 A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

0003 In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

0004 Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

0005 It is desirable to monitor certain vertical parameters of interest (e.g., dimensional parameters in a direction perpendicular to the substrate plane). Such vertical parameters of interest may impact device yield and/or performance; notable examples including the recess depth of Replacement Metal Gate in both FinFET (fin field-effect-transistor) and CFET (complementary field-effect-transistor) devices, or gate height in BCAT (Buried Channel Array Transistor) devices in DRAM (dynamic random access memory). Thus, it is desirable to provide enhanced methods to monitor such vertical parameters of interest.

### SUMMARY

0006 The invention in a first aspect provides a method of determining at least one vertical parameter of interest relating to a structure of interest on a substrate comprising: obtaining first metrology data and/or data derived therefrom, the first metrology data relating to a measurement of the structure of interest when not comprising a layer of interest to which the vertical parameter of interest relates, or a representative structure being representative of the structure of interest when not comprising the layer of interest; obtaining second metrology data relating to a measurement of the structure of interest when comprising the layer of interest; removing the first metrology data and/or data derived therefrom from the second metrology data to obtain residual metrology data; obtaining at least one model to relate the residual metrology data to the vertical parameter of interest; and using the model to derive the vertical parameter of interest from the residual metrology data.

0007 The invention in a second aspect provides a substrate comprising: a plurality of training targets, each training target comprising a plurality of sub-targets, wherein a correlated parameter is varied over the plurality of sub-targets, the correlated parameter being correlated with a vertical parameter of interest of the training target, the training target being representative of a structure of interest; wherein all layers of the training targets which affect the vertical parameter interest and which are below the layer of interest, have been exposed and processed similarly to the structure of interest.

### BRIEF DESCRIPTION OF THE DRAWINGS

0008 Embodiments of the invention will now be described, by way of example only, with reference to the accompanying schematic drawings in which corresponding reference symbols indicate corresponding parts, and in which:
Figure 1 depicts a lithographic apparatus;
Figure 2 depicts a lithographic cell or cluster in which an inspection apparatus according to the present invention may be used;
Figure 3 illustrates schematically inspection apparatus adapted to perform angle-resolved scatterometry and dark-field imaging inspection methods;
Figure 4 illustrates schematically a metrology target which may be used in methods disclosed herein;
Figure 5 is a flowchart describing a model training method according to an embodiment of concepts disclosed herein, for determining a model which maps metrology data to a vertical parameter of interest; and
Figure 6 is a flowchart describing a vertical parameter of interest inference method using a model trained according to the method of Figure 5.

### DETAILED DESCRIPTION

0009 Before describing embodiments of the invention in detail, it is instructive to present an example environment in which embodiments of the present invention may be implemented.

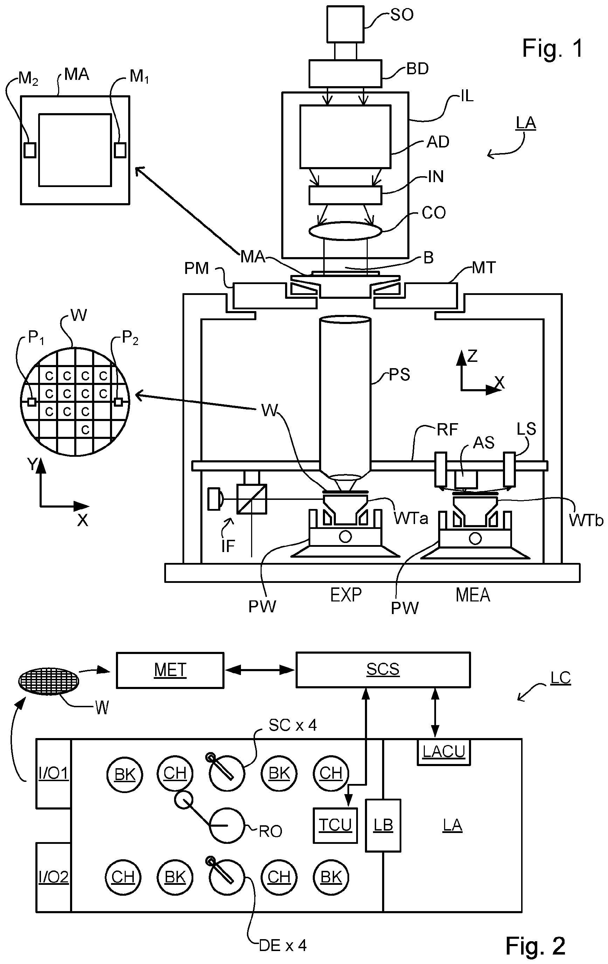

0010 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0011 The illumination system may include various types of optical components, such as refractive, reflective, magnetic, electromagnetic, electrostatic or other types of optical components, or any combination thereof, for directing, shaping, or controlling radiation.

0012 The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

0013 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0014 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0015 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0016 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0017 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0018 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0019 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

0020 Patterning device (e.g., reticle/mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

0021 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

0022 Combinations and/or variations on the above described modes of use or entirely different modes of use may also be employed.

0023 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0024 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0025 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0026 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information. For example, after-etch measurements provide feedback opportunities for an etch tool (or more generally any processing tool). The metrology that allows lithography-rework typically relates to parameters in the x-y plane, such as CD and overlay. Vertical parameters of interest are typically created only after-etch, or after chemical mechanical polishing (CMP).

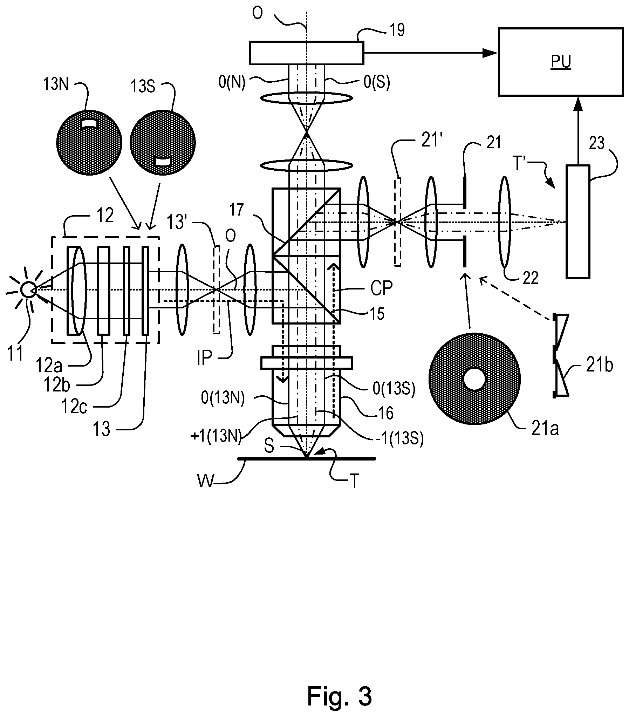

0027 A metrology apparatus suitable for use in embodiments of the invention is shown in Figure 3. Note that this is only one example of a suitable metrology apparatus. An alternative suitable metrology apparatus may use EUV radiation such as, for example, that disclosed in WO2017/186483A1. The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

0028 Target structure T may be placed with substrate W normal to the optical axis O of objective lens 16. The substrate W may be supported by a support (not shown). A ray of measurement radiation Iimpinging on target structure T from an angle off the axis O gives rise to a zeroth order ray (solid line 0) and two first order rays (dot-chain line +1 and double dot-chain line -1), hereafter referred to as a pair of complementary diffraction orders. It should be noted that the pair of complementary diffraction orders may be any higher order pair; e.g., the +2, -2 pair etc. and is not limited to the first order complementary pair. It should be remembered that with an overfilled small target structure, these rays are just one of many parallel rays covering the area of the substrate including metrology target structure T and other features. Since the aperture in plate 13 has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 3 are shown somewhat off axis, purely to enable them to be more easily distinguished in the diagram.

0029 At least the 0 order (and optionally +1 orders) diffracted by the target structure T on substrate W are collected by objective lens 16 and directed back through beam splitter 15. Both of the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

0030 A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

0031 It is this first measurement branch which may be used to obtain the pupil images or pupils for the methods disclosed herein. In particular, the targets/structures measured in methods described herein may be too small (i.e., in terms of pitch) for any (non-zero) diffraction orders to be captured within the numerical aperture of the metrology tool (unless the measurement radiation comprises very small wavelengths, e.g., in the EUV or soft X-ray range). Therefore, a challenge in measuring vertical parameters of interest is the metrology signals may typically comprise only reflected (zero order) signals. As such, the methods disclosed herein may measure and use multi-dimensional reflection metrology data such as pupil images (i.e., angularly resolved metrology data). As an alternative (or in addition) to angularly resolved metrology data, the multi-dimensional reflection metrology data may comprise wavelength resolved metrology data (e.g., where the metrology tool used is a wavelength-resolved scatterometer (e.g., having fewer incidence/detection angles than the tool illustrated here).

0032 In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

0033 Besides the lithographic apparatus LA and the metrology apparatus MT, one or more other processing apparatuses may be used during device production as well. An etching station (not shown) processes the substrates after exposure of the pattern into the resist. The etch station transfers the pattern from the resist into one or more layers underlying the resist layer. Typically etching is based on application of a plasma medium. One or more local etching characteristics may e.g. be controlled using temperature control of the substrate or directing the plasma medium using a voltage controlled ring. More information on etching control can be found in PCT Patent Application Publication No. WO 2011-081645 and U.S. Patent Application Publication No. US 2006-016561, which are incorporated herein in their entireties by reference.

0034 During the manufacturing of devices, it is desired that the process conditions for processing substrates using one or more processing apparatuses such as the lithographic apparatus or etching station remain stable such that properties of the features remain within certain control limits. Stability of the process is of particular significance for features of the functional parts of an electric device such as an IC, also referred to as product features. To help ensure stable processing, process control capabilities should be in place. Process control involves monitoring of processing data and implementation of means for process correction, e.g. control a processing apparatus based on one or more characteristics of the processing data. Process control may be based on periodic measurement by the metrology apparatus MT, often referred to as "Advanced Process Control" (further also referenced to as APC). More information on APC can be found in U.S. Patent Application Publication No. US 2012-008127, which is incorporated herein in its entirety by reference. A typical APC implementation involves periodic measurements on metrology features on the substrates to monitor and correct drifts associated with one or more processing apparatuses. The metrology features reflect the response to process variations of the product features. The sensitivity of the metrology features to process variations may be different compared to the sensitivity to the product features. In that case, a so-called "Metrology To Device" offset (also referenced to as MTD) may be determined.

0035 One reason for this is MTD offset is that the actual product structures are often much (orders of magnitude) smaller than the size of the target structures which are required for scatterometry or imaging measurements, and this difference in size can result in different parameter behavior (e.g., pattern placement and resulting overlay for metrology targets may differ from pattern placement and resulting overlay of actual structures). To mimic the behavior of product features, features within the metrology targets may be made smaller (e.g., of comparable size to the product structures, which can be referred to as at-resolution overlay ARO), incorporate segmented features, assist features or features with a particular geometry and/or dimension. A carefully designed metrology target ideally should respond in a similar fashion to process variations as do the product features. More information on metrology target design can be found in PCT Patent Application Publication No. WO 2015-101458 which is incorporated herein in its entirety by reference.

0036 In another approach, metrology may be performed directly on the product structure. This can be done using a scanning electron microscope (SEM) or an e-beam metrology apparatus for example. However, these devices are typically too slow for process control in a commercial (high-volume manufacturing HVM) environment. A known metrology technique is known as in-device metrology (IDM). In IDM, a wafer is measured (e.g., after-etch) using, for example, a metrology tool such as illustrated in Figure 3(a) (using the pupil imaging branch). The resulting optical signals, typically referred to herein as "pupils", each comprise an angularly resolved spectrum of measured values or signal parameter values (e.g., intensities, diffraction efficiencies or any other suitable parameter). These pupils are obtained from radiation scattered from a "target" on the substrate, and may comprise radiation from any one or more diffraction orders, where a diffraction order in this context includes the zeroth order (specularly reflected radiation). As such, a pupil may be obtained from only the zeroth order, only a single higher order or a combination of orders.

0037 In an embodiment, a pupil of the scattered radiation is measured, i.e., at a Fourier transform plane. The term pupil and pupil plane herein includes any conjugates thereof unless the context otherwise requires (for example, where a pupil plane of a particular optical system is being identified). 0038 As has been outlined above, metrology may be performed on structures formed by a lithographic process to obtain metrology data. This metrology data will be indicative of the performance of the lithographic process and/or other processing steps performed as part of an IC manufacturing process (e.g., etch steps). For example, any timed etch process or chemical mechanical polish process will create variations across wafer in terms of depth, height, or thickness of device structures, which could be important for yield or performance. Corrections which correct for measured parameters that differ from a target value for that parameter may be determined based on the metrology data, and used in subsequent performances of the lithographic process and/or other processing steps (e.g., on subsequent substrates and/or lots).

0039 Parameters of interest to be monitored may comprise vertical parameters of interest, e.g., one or more dimensional parameters (heights/depths) in the vertical direction or z-direction perpendicular to the substrate plane. Such vertical parameters of interest include *inter alia* etch depth, gate height, silicon fin height or height of a portion of the fin revealed above the insulating oxide (e.g., in FinFET devices), any electrode height, dielectric thickness, height of a metal line, layer height (e.g., after chemical-mechanical polishing CMP).

0040 Measurement of these vertical parameters of interest are often affected by nuisance contributors resultant from previous layers of the stack. Variation of these nuisance contributors are typically cross-correlated with variation of the vertical parameter of interest, such that it is difficult or impossible to disentangle a vertical parameter of interest from the nuisance contributors when performing metrology to determine the vertical parameter of interest. In this context, a nuisance contributor comprises any stack parameter (e.g., below a layer of interest for which the vertical parameter of interest is comprised), such as any geometric or physical parameters of the device, which affect the same part of the metrology signal as the vertical parameter of interest, e.g., and which have a similar shape/fingerprint/response function.

0041 One method of measuring such vertical parameters of interest, is to measure them on dedicated metrology targets. To aid measurement, such targets are often significantly larger than the product structures. However, this can mean that they are not sufficiently representative of the functional structures, and behave differently such that the measurement will not be truly representative of the vertical parameters of interest for the product structure.

0042 Another approach may use high resolution metrology tools to measure the vertical parameters of interest directly on the product structure. Such high-resolution metrology tools may have sufficient resolution to directly resolve the vertical parameter of interest, obviating the problem of nuisance contributors. Such high-resolution metrology tools may include *inter alia* a scanning electron microscope (SEM), transmission electron microscope (TEM), X-ray secondary emission microscope (XSEM) or atomic force microscope (AFM). However, this type of metrology is slow and often destructive and therefore cannot be used for process control on functional product and/or in high-volume manufacturing (HVM).

0043 It is known also to use a metrology tool such as illustrated in Figure 3, and in particular to use the pupil branch (angularly resolved imaging branch) to obtain angularly resolved metrology data, otherwise referred to as pupils (or pupil images). These can be compared to simulated pupils based on simulating measurement of an estimate of the structure in terms of estimated stack parameters (an estimated physical description) including the vertical parameter of interest and all relevant nuisance contributors. The stack parameters may be optimized in a reconstruction method till differences between the simulated pupils and measured pupils are minimized. However, such reconstruction techniques are relatively slow as the parameter space may be large and therefore the optimization computationally expensive. In particular, for more complex stacks such as middle-of-line (MOL) and back-end-of-line (BEOL) stacks, the number of parameters and overall parameter space will be very large with excessive parameter cross-correlations, making such metrology impractical and non robust, particularly in an HVM setting.

0044 To address one or more of these issues, improved methods for measuring one or more vertical parameters of interest are proposed which better disentangle the vertical parameter of interest from nuisance contributors.

0045 The proposed method may be data-driven, thereby removing the issue of the complexity of physics-based models (parameter descriptions) required for reconstruction methods. Such a data driven method requires a training of the model.

0046 To improve methods for generating training data for model training, in an embodiment, a new type of training target is also proposed. The proposed training target comprises at least two sub-targets over which a correlated parameter is varied. In this context a correlated parameter is a parameter which can be controllably and deliberately varied via lithography or other processing step, e.g., by varying a corresponding feature on a reticle used in a lithography step, and which has a strong correlation with the vertical parameter of interest. For example, a correlated parameter may comprise a stack parameter which affects formation and/or processing of the vertical parameter of interest (i.e., has any impact on a vertical parameter of interest value).

0047 A specific example will be described in detail below, comprising a training target for which a critical dimension (CD) parameter such as trench CD is varied over the target (e.g., such that each sub-target is exposed with a different CD parameter value. Such a training target may be used to generate training data, for example, when the vertical parameter of interest is the recess depth of Replacement Metal Gate in both FinFET and CFET devices, or gate height in Buried Channel Array Transistors (BCAT) in DRAM. Both of these vertical parameters have a strong and predictable correlation and therefore relationship with trench CD, due (in this specific example) to aspect-ratio-dependent etch.

0048 The proposed training target may be similar and processed similarly to the device from the layer of interest down to the most relevant lower layers (e.g., those responsible for nuisance contributors which affect the vertical parameter of interest and/or the measurement thereof). As such, any lower layer which substantially affects the vertical parameter of interest should be exposed and processed (e.g., etch, CMP etc.) in the same manner as the product structure it represents. Other layers which have little or negligible effect on the vertical parameter of interest may be ignored for the training target to reduce the stack complexity.

0049 Where the product structure that the target represents is periodic, the training target may be substantially identical to the product structure for at least the relevant lower layers which affect the parameter of interest. When the product structure is not periodic, then the training target may be a periodic approximation or representation of the product structure, to enable scatterometry measurement. For example, logic devices, which tend to be irregular, typically comprise memory caches (SRAM) which are periodic and have similar dimensions to the irregular logic cells, and hence are sufficiently representative. Scatterometry-based measurements of logic structure within logic dies could be carried out on such SRAM cells, wherein the SRAM cells are representative structure for the logic structure.

0050 In an embodiment, the training target may comprise three sub-targets. A first sub-target may comprise a nominal value for the correlated parameter such as a nominal CD (e.g., and nominal target pitch), for example which is the same as that of a device feature it represents. The second and third sub-target may respectively comprise a correlated parameter value such as CD (e.g., and target pitch) either side of the nominal correlated parameter value/CD (e.g., and nominal target pitch). Optionally, the difference in the correlated parameter value between the first sub-target and second sub-target may have substantially the same or similar magnitude as the difference in the correlated parameter value between the first sub-target and third sub-target. The correlated parameter value over the training target may be sufficient at least to cover any vertical parameter of interest variation likely encountered, or might be encountered, in HVM (taking into account the relationship between the parameters) and possibly a significantly greater range. By varying a correlated parameter in a controllable way for a number of training targets, it is possible to significantly increase the variation of the parameter of interest within the training data, and therefore the training quality. For example, in the specific example which will be described, the proposed target design benefits from aspect-ratio dependent etch, which will lead to different etch depths within the target (larger CDs will etch deeper).

0051 The fixed, intra-target relationship between the correlated parameter such as trench CD and the vertical parameter of interest (e.g., etch/recess depth or gate height) can be established as a one-time training step using only a few training targets on wafer. This relationship can then be used to effectively generate additional ground truth reference data "for free". More specifically, the ground-truth reference data is typically measured using a high-resolution metrology tool which is slow and/or destructive. Therefore, it is highly desirable to reduce the amount of high-resolution metrology required.

0052 The proposed training target enables the possibility of determining the intra-target (CD-to-trench depth) relationship by performing high-resolution metrology on only a (e.g., very) small subset of the training targets. For the remaining training targets (e.g., the majority of the training targets), it is proposed to measure only one sub-target per target, e.g., the first or nominal sub-target, using high-resolution metrology. Then per-target, the measured ground-truth value for that target can be used in combination with the determined intra-target relationship to determine ground truth values for the other sub-targets of that target. This reduces the number of high-resolution measurements by approximately a factor of three (assuming a training target of three sub-targets). In some occasions, the relationship between the vertical parameter of interest and the correlated parameter is well-known by the IC manufacturer from prior experience, in which cases the relationship does not have to be freshly established (e.g., it comes "for free").

0053 Note that the proposed training target may have any number of two or more sub-targets. If only a linear intra-target model is being fitted, the target may comprise only two sub-targets (e.g., comprising a CD either side of the product CD). However, better performance may be obtained using three sub-targets including a nominal target as most variation will be close to nominal. More than three sub-targets may be used per target, which might further improve training and provide more ground-truth training data. However, this would be at the cost of reticle/substrate real-estate as the training target may be provided on the production reticle (e.g., one or more training targets per reticle/field).

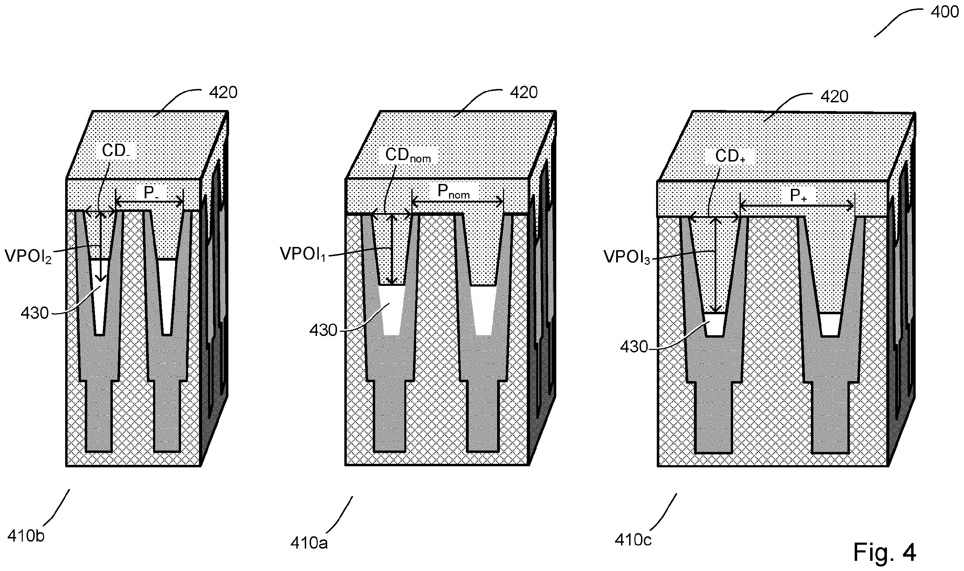

0054 Figure 4 is a schematic drawing of an example training target 400 for a DRAM-BCAT example use-case, where the vertical parameter of interest is the recess depth of the metal gate VPOI , VPOI₂, VPOI₃. The training target 400 comprises a first sub-target 410a, second sub-target 410b and third sub-target 410c. The layer of interest is the metal gate layer 420. All relevant layers below this metal gate layer 420 which affect the recess depth of the metal gate VPOI₁ have been exposed and processed.

0055 First sub-target 410a is formed with a first CD or nominal CD CDₙₒₘ for the trench 430 into which the metal gate is to extend. This nominal CD CDₙₒₘ may be the same or similar to the CD of the product structure of which the training target 400 is representative. The first sub-target 430a may also comprise a first pitch or nominal pitch Pₙₒₘ, which may be the same or similar to the pitch of the product structure (e.g., where it is periodic) of which the training target 400 is representative.

0056 Second sub-target 410b is formed with a second CD CD₋ for the trench 430 into which the metal gate is to extend. This second CD CD₋ may be smaller than the nominal CD (e.g., deliberately detuned with respect to the nominal CD). The second sub-target 430b may also comprise a second pitch P₋ which may be smaller than the nominal pitch Pₙₒₘ. The difference between the first CD and second CD may be between 1nm and 10nm, between 1nm and 8nm or between 2nm and 6nm for example.

0057 Third sub-target 410c is formed with a third CD CD₊ for the trench 430 into which the metal gate is to extend. This third CD CD₊ may be larger than the nominal CD. The third sub-target 430c may also comprise a third pitch P₊ which may be larger than the nominal pitch Pₙₒₘ. The difference between the first CD and third CD may be between 1nm and 10nm, between 1nm and 8nm or between 2nm and 6nm for example. The differences of the second CD and third CD with respect to the first CD may be equal in magnitude (although this is not required).

0058 As such, the three sub-targets comprising nominal trench CDₙₒₘ and detuned trench CD₊. CD₋, results in a (mostly) predictable intra-mark metal gate height and/or recess depth variation VPOI₁, VPOI₂, VPOI₃ due to aspect-ratio-dependent etch.

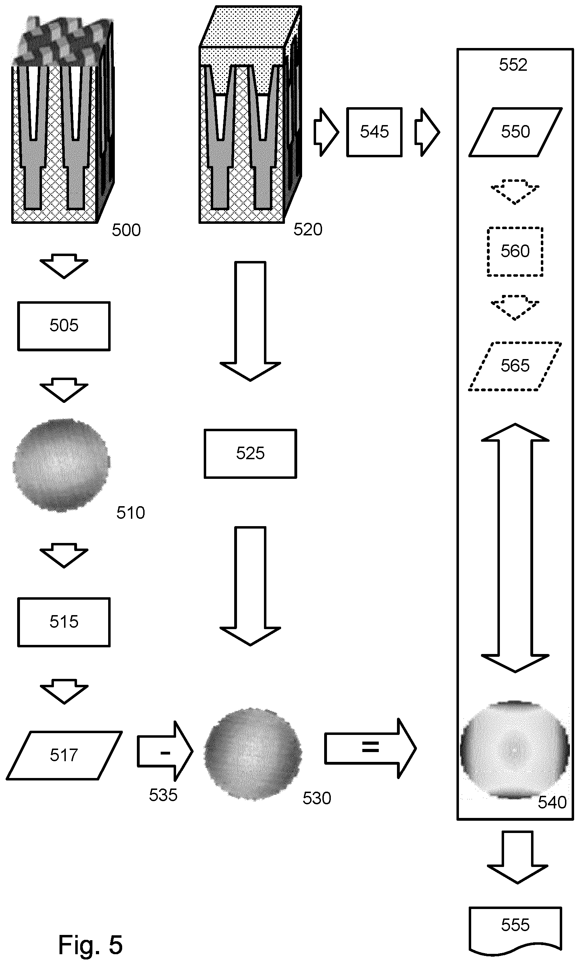

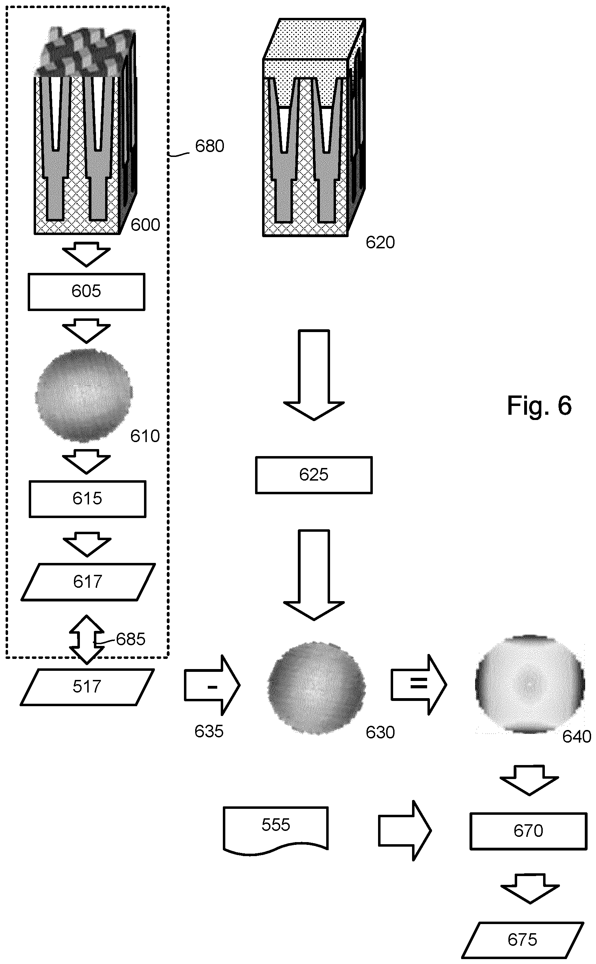

0059 Figures 5 and 6 relate to a vertical parameter of interest metrology method which may be used to infer a vertical parameter of interest such as any of those mentioned above. The method may use the training target of Figure 4 and/or as disclosed herein, although this is optional e.g., to increase the amount and/or improve the quality of the training data. As such, the methods may be performed without the proposed training targets, and may use another form of representative structure.

0060 The proposed method comprises a training or recipe setup phase which trains a model and an inference phase (e.g., production phase or HVM phase) in which the trained inference model is used to infer the vertical parameter of interest from metrology data (e.g., scatterometer metrology data such as pupil data or angularly resolved metrology data).

0061 Figure 5 is a flow diagram illustrating a proposed training phase according to the concepts disclosed herein. A plurality (e.g., one or more per field) of partial training structures (e.g., partial representative structures) 500 is patterned and/or processed, e.g., over multiple layers, to form a stack structure which does not comprise the layer of interest (i.e., a layer for which the vertical parameter of interest relates and/or is a dimension of). The partial training structure 500 shown is a purely illustrative example comprising an etched trench which has not been filled with the metal (e.g., the metal layer of interest has not been added). Each partial training structure 500 may comprise all layers that affect or impact on the vertical parameter of interest, but does not necessarily need to include layers which do not (leaving out layers which have negligible impact on the vertical parameter of interest may have the advantage of simplifying the training structure). Each partial training structure may be a dedicated training target formed for the purposes of metrology or a (partially complete) functional product structure.

0062 Each partial training structure may comprise a training target such as that described above, comprising at least two sub-targets having a difference in a correlated parameter which has a strong correlation with the vertical parameter of interest, prior to formation of the layer of interest. In an embodiment, the training target may comprise three sub-targets, e.g., one having a nominal value for the correlated parameter, and the other two having values either side of the nominal value for the correlated parameter. A specific example for a particular use-case (DRAM BCAT) may comprise the target 400 of Figure 4 prior to formation of layer of interest 420.

0063 Step 505 comprises a first training metrology step comprising measuring the partial training structures 500. This first training metrology step 505 may be performed using a scatterometer to obtain first training pupil data (first angularly resolved data or first training angularly resolved data) 510. This first training pupil data may be used to reduce cross-correlations between the vertical parameter of interest and nuisance contributors resulting from layers below the layer of interest. This first training pupil data contains information about all the sources of stack variation that are not related to the vertical parameter of interest, i.e., the nuisance sources of variation. It can be appreciated that the nuisance variation comprised within the first training pupil data includes the correlated parameter (e.g., trench CD) which was varied in the training target, as cross-correlations in such training targets result not only from stack variations in the bottom layer, but also from the intra-target CD variation.

0064 At step 515, a decomposition algorithm may be used to extract the major or dominant nuisance-related variation modes or training dominant mode data 517 comprised within the first training pupil data 510. The decomposition algorithm may comprise a component analysis algorithm such as principal component analysis (PCA).

0065 After a patterning and/or processing step to form the layer of interest (e.g., in the specific example this step may comprise metal fill and etch back process steps to form a metal layer), the training structures (representative structures) or training targets 520 are measured again in second training metrology step 525 to obtain second training pupil data or second training angularly resolved data 530. The nuisance modes or nuisance variation modes 517 are removed 535 from the second training pupil data 530, e.g. by projecting out the most dominant PCA modes (principal components) 517 identified at step 515 from the second training pupil data 530. The result of step 535 is residual training pupil data or residual training angularly resolved data 540. The number of the most dominant PCA modes projected out from the second training pupil data 530 may be between 1 and 5 or between 1 and 10, for example.

0066 At step 545, a tool of reference such as a high-resolution metrology tool may be used to measure the training structures or training targets 520 to obtain ground truth data 550 for the vertical parameter of interest. This is one example of obtaining the ground truth data 550, the ground truth data 550 may be obtained by any other suitable means.

0067 In a training step 552, a suitable model 555 may be trained to map the residual training pupil data 540 to the ground truth data 550. The model 555 may be an inference model (fitted model) or a machine learning (e.g., neural network) model for example. If an inference model, the model may comprise a linear inference model such as a least-squares or partial least-squares inference model. If a machine learning model, the machine learning model may be a convolutional neural network CNN. More specifically, the CNN may comprise an input layer, an output layer and hidden layers therebetween. The hidden layers may comprise, for example, a number of repetitions of convolution layers, activation layers, and batch normalization layers, followed by one or more dropout layers and one or more full connection layers.

0068 Any suitable training method may be used, such as a model (e.g., least-squares) regression or supervised machine learning training, depending on the model type.

0069 Training step 552 may also comprise a step 560 of expanding the amount of ground truth data. This step 560 relies on the training target being of a type disclosed herein and described above, comprising a plurality of sub-targets with a varied correlated parameter. In such an embodiment, initial measured ground truth data 550 comprises tool of reference metrology data for all of the sub-targets of only a small subset of the training targets. For the remaining training targets, the tool of reference is used to only measure one sub-target per training target. Step 560 comprises fitting an intra-target model which relates the lithographic parameter to the vertical parameter of interest and determining tool of reference values for the sub-targets not directly measured to obtain expanded ground truth data 565. The training then done using the expanded ground truth data 565 and residual training pupil data 540. The expansion in the volume of training data is generally beneficial, particularly for complex inference algorithms with multiple (hyper)parameters.

0070 The result of this training method is a determined model 555 (e.g., trained model, any other model, or determined recipe). This training method may be performed on one or more initial substrates of a lot or number of lots, for example. The trained model can then be used to infer the vertical parameter of interest on the remaining wafers of the lot or plurality of lots (e.g., as part of HVM production).

0071 Figure 6 describes an inference method according to an embodiment. A structure 620 on a substrate is measured in a production metrology step 625 using a scatterometer to obtain production pupil data or second angularly resolved metrology data 630. The structure 620 may be actual product structure (e.g., the actual product structure being monitored), provided it is sufficiently periodic, or it may be proxy product structure (e.g., a metrology target or any other structure which is representative of the product structure being monitored). The structure 620 measured at production metrology step 625 comprises the layer of interest (i.e., it is measured after the patterning and/or processing step to form the layer of interest).

0072 The principal components or training dominant mode data 517 determined during the training are removed 635 from the production pupil data 630 to obtain production residual angularly resolved data 640. An inference step 670 comprises applying the trained model 555, having been trained on training structures or training targets representative of structure 620 (e.g., using the method illustrated in Figure 5), to the production residual data 640, so as to infer the vertical parameter of interest 675.

0073 In the described inference method, the first training metrology step 505 is performed as a one-time measurement during training, with the determined dominant mode data 517 used during the inference phase. As an optional refinement, a mode monitoring step 680 may be performed. Such a mode monitoring step 680 may comprise performing routine or occasional scatterometry metrology 605 on partial structure 600, the partial structure comprising the structure 620 prior to patterning of the layer of interest, to obtain mode monitoring pupil (or angularly resolved) data 610. In many cases, this additional metrology 605 has an impact on throughput; there will always be a throughput impact unless metrology needs to be performed on the stack 600 prior to patterning the layer of interest for another reason, e.g., to monitor another parameter such as overlay. As such, it may be that the mode monitoring step 680 is performed only occasionally.

0074 A decomposition algorithm (e.g., PCA) may be applied 615 to the mode monitoring pupil data 610, thereby obtaining updated dominant mode data 617. This updated dominant mode data 617 can be compared 685 to the training dominant mode data 517 (or previously updated dominant mode data as appropriate), and an appropriate action taken based on the comparison.

0075 For example, the comparison may be used as a performance indicator to flag and correct for large process variations that were not present in the training phase and that could adversely impact the inference performance. This may comprise determining whether the updated dominant mode data 617 are significantly different from the dominant mode data 517 observed during the setup phase. For example, if new modes are identified, the dominant mode data 517 may be updated, e.g., by adding any newly identified process-related signal modes to the library of existing modes and using these in subsequent inference iterations. Alternatively, it may be determined whether any (quantified) difference exceeds at least one threshold value and retraining the model 555 if the difference is higher than the threshold.

0076 Of course, it is also possible to determine the dominant mode data for each substrate rather than using previously determined dominant mode data 517, e.g., by measuring partial structure 600 per substrate to obtain first angularly resolved data and performing a PCA step thereon. However, this is unlikely to be a practical implementation, likely being too slow for HVM production.

0077 The angularly resolved metrology data described in the above mentioned embodiment may be obtained from one or more metrology signals derived from detected radiation scattered by one or more structures at an angularly resolved plane of the metrology apparatus. A metrology signal in the context may comprise a raw pupil image or a processed pupil image, where a pupil is an angularly resolved representation of the scattered radiation as captured at the angularly resolved plane (e.g., a pupil plane or a conjugate thereof). A processed pupil image may comprise a pupil image data in any form, including for example, one or more of: representation as a vector or matrix (e.g., of intensities, diffraction efficiencies or any other suitable parameter values) and/or having undergone any other processing techniques such as dimensionality reduction.

0078 While the embodiments described herein, are described in the context of angularly resolved metrology data, the metrology data (i.e., first metrology data, second metrology data and/or residual metrology data) does not need to be such angularly resolved metrology data. For example, each of these metrology data may comprise other reflection spectrum data, such as wavelength resolved metrology data. Such wavelength resolved metrology data may comprise, for example, one or more wavelength-resolved reflection intensity signals at a fixed or at multiple incidence and/or detection angles, i.e., a reflection spectrum. The ideas described above are equally applicable to such metrology techniques.

0079 By way of a specific example, the pupils described herein may each comprise a symmetric component of co-polarized pupils. The incident measurement radiation used to measure a structure may be polarized and a cross-polarizer used on the scattered radiation to divide the scattered radiation into two measurement channels: a cross-polarized channel (which provides cross-polarized pupils) and a co-polarized channel (which provides co-polarized pupils). An inference algorithm is used to infer a parameter of interest from the pupils, based on knowledge of the physics and process. In conventional IDM, the cross-polarized pupils are used to infer asymmetric parameters (e.g., overlay or tilts) and the co-polarized pupils used to infer symmetric parameters (e.g., critical dimension (CD) and height).

0080 Further embodiments are disclosed in the subsequent numbered clauses:
1. A method of determining at least one vertical parameter of interest relating to a structure of interest on a substrate comprising:
   obtaining first metrology data and/or data derived therefrom, the first metrology data relating to a measurement of the structure of interest when not comprising a layer of interest to which the vertical parameter of interest relates, or a representative structure being representative of the structure of interest when not comprising the layer of interest;
   obtaining second metrology data relating to a measurement of the structure of interest when comprising the layer of interest;
   removing the first metrology data and/or data derived therefrom from the second metrology data to obtain residual metrology data;
   obtaining at least one model to relate the residual metrology data to the vertical parameter of interest; and
   using the model to derive the vertical parameter of interest from the residual metrology data.
2. A method according to clause 1, wherein the model is a trained model.
3. A method according to clause 1 or 2, wherein the first metrology data and/or data derived therefrom comprises dominant mode data derived from the first metrology data.
4. A method according to clause 3, comprising applying a decomposition algorithm to the first metrology data to obtain the dominant mode data.
5. A method according to clause 4, wherein the decomposition algorithm comprises a principal component analysis.
6. A method according to any of clauses 3 to 5, wherein at least some of the dominant mode data comprises training dominant mode data derived from the first metrology data having been measured in a training phase on partial training structure, the partial training structure being at least representative of the structure of interest when not comprising the layer of interest.
7. A method according to any of clauses 3 to 6, comprising obtaining and/or determining updated dominant mode data having been measured on the structure of interest when not comprising the layer of interest;
   comparing the updated dominant mode data to the previous dominant mode data; and
   deciding whether to perform an update action based on the comparison.
8. A method according to clause 7, wherein the update action comprises adding one or more newly identified modes to the dominant mode data.
9. A method according to clause 7, wherein the update action comprises retraining the trained model.
10. A method according to any preceding clause, wherein the vertical parameter of interest comprises a dimensional parameter in a direction perpendicular to a substrate plane defined by the substrate.
11. A method according to any preceding clause, wherein the vertical parameter of interest comprises at least one of etch depth, gate height, silicon fin height, any electrode height, thickness of the layer of interest, dielectric thickness, height of a metal line.
12. A method according to any preceding clause, wherein the structure of interest comprises a functional product structure.
13. A method according to any preceding clause, wherein the first metrology data, second metrology data and the residual metrology data each comprise multi-dimensional reflection metrology data and/or reflection spectrum data.
14. A method according to any preceding clause, wherein the first metrology data, second metrology data and the residual metrology data each comprise angularly resolved data.
15. A method according to any preceding clause, wherein the first metrology data, second metrology data and the residual metrology data each comprise wavelength resolved data.
16. A method according to any preceding clause, wherein the first metrology data relates to a measurement of the structure of interest performed by illuminating the structure of interest or representative structure with a radiation beam and detecting radiation scattered by the structure of interest prior to a patterning and/or processing step to form the layer of interest; and
   wherein the second metrology data relates to a measurement of the structure of interest performed by illuminating the structure of interest with a radiation beam and detecting radiation scattered by the structure of interest subsequently to the patterning and/or processing step.
17. A method according to any preceding clause, comprising performing an initial training phase to train the model to obtain the trained model, the method comprising:
   obtaining first training metrology data and/or data derived therefrom, the first training metrology data relating to a measurement of a plurality of partial training structures, the partial training structures being at least representative of the structure of interest when not comprising the layer of interest;
   obtaining second training metrology data relating to a measurement of training structures, the training structures comprising the partial training structures when comprising the layer of interest;
   removing the first training metrology data and/or data derived therefrom from the second training metrology data to obtain residual training metrology data; and
   training the model to relate the residual training metrology data to the vertical parameter of interest using the residual training metrology data and ground truth data for the vertical parameter of interest.
18. A method according to any clause 17, wherein the first training metrology data relates to a measurement of the partial training structures performed by illuminating the partial training structures with a radiation beam and detecting radiation scattered by the partial training structures prior to a patterning and/or processing step to form the layer of interest; and
   wherein the second training metrology data relates to a measurement of the training structures performed by illuminating the training structures with a radiation beam and detecting radiation scattered by the training structures subsequently to the patterning and/or processing step.
19. A method according to clause 17 or 18, wherein all layers of the training structures which affect the vertical parameter interest and which are below the layer of interest, have been exposed and processed similarly to the structure of interest.
20. A method according to clause any of clauses 17 to 19, wherein the first training metrology data and/or data derived therefrom comprises training dominant mode data derived from the first training metrology data.
21. A method according to clause 20, comprising applying a decomposition algorithm to the first training metrology data to obtain the training dominant mode data.
22. A method according to clause 21, wherein the decomposition algorithm comprises a principal component analysis.
23. A method according to any of clauses 18 to 22, wherein the training structures comprise training targets, each training target comprising a plurality of sub-targets, wherein a correlated parameter is varied over the plurality of sub-targets, the correlated parameter being correlated with the vertical parameter of interest.
24. A method according to clause 23, wherein the correlated parameter comprises a dimensional parameter in at least one substrate plane dimension.
25. A method according to clause 23 or 24, wherein the dimensional parameter comprises a critical dimension parameter.
26. A method according to any of clauses 23 to 25, wherein the correlated parameter is varied over the plurality of sub-targets by varying a corresponding feature parameter on a reticle used to expose the training targets.
27. A method according to any of clauses 23 to 26, wherein the training target comprises a first sub-target having a nominal value for the correlated parameter, a second sub-target having a value less than the nominal value for the correlated parameter and a third sub-target having a value greater than the nominal value for the correlated parameter.
28. A method according to any of clauses 23 to 27, further comprising:
   obtaining initial ground truth data comprising measured values for only one sub-target per training target for some or all of the training targets;
   obtaining an intra-target relationship between the correlated parameter and the vertical parameter of interest; and
   determining values for sub-targets not having measured values in the initial ground truth data, from the intra-target relationship and the measured values in the initial ground truth data, to obtain the ground truth data for training.
29. A method according to clause 28, wherein the intra-target relationship is determined from expert knowledge.
30. A method according to clause 28 or 29, comprising determining the intra-target relationship from a subset of the initial ground truth data comprising values for all the sub-targets of a subset of the training targets, and corresponding values for the correlated parameter.
31. A method according to any of clauses 28 to 30, comprising measuring the training structures using a high resolution tool to obtain the ground truth data or the initial ground truth data.
32. A method according to any of clauses 17 to 31, comprising measuring the training structures respectively prior to, and subsequent to, a patterning and/or processing step to form the layer of interest to obtain the first training metrology data and the second training metrology data.
33. A method according to any of clauses 17 to 32, wherein the first training metrology data, second training metrology data and the residual training metrology data each comprise multi-dimensional reflection metrology data and/or reflection spectrum data.
34. A method according to any of clauses 17 to 33, wherein the first training metrology data, second training metrology data and the residual training metrology data each comprise angularly resolved data.
35. A method according to any of clauses 17 to 34, wherein the first training metrology data, second training metrology data and the residual training metrology data each comprise wavelength resolved data.
36. A method according to any of clauses 17 to 35, wherein the steps of measuring the training structures to obtain the first training metrology data and the second training metrology data and/or the step of measuring the structure of interest to obtain the second metrology data is performed using a scatterometer.
37. A method according to any preceding clause, comprising the step of measuring the structure of interest, to obtain the second metrology data.
38. A method according to any preceding clause, wherein at least the second metrology data comprises processed data comprising only a symmetrical component of the second metrology data.
39. A method according to any preceding clause, wherein the trained model comprises a regression model or a machine learning model.
40. A method according to any preceding clause, wherein at least some of the first metrology data comprises training first metrology data having been measured in a training phase on partial training structure, the partial training structure being at least representative of the structure of interest when not comprising the layer of interest.
41. A substrate comprising:
   a plurality of training targets, each training target comprising a plurality of sub-targets, wherein a correlated parameter is varied over the plurality of sub-targets, the correlated parameter being correlated with a vertical parameter of interest of the training target, the training target being representative of a structure of interest;
   wherein all layers of the training targets which affect the vertical parameter interest and which are below the layer of interest, have been exposed and processed similarly to the structure of interest.
42. A substrate according to clause 41, wherein the correlated parameter comprises a dimensional parameter in at least one substrate plane dimension.
43. A substrate according to clause 41 or 42, wherein the dimensional parameter comprises a critical dimension parameter.
44. A substrate according to clause 41, 42 or 43, wherein the correlated parameter is determined by a corresponding feature parameter on a reticle used to expose the training targets.
45. A substrate according to any of clauses 41 to 43, wherein the training target comprises a first sub-target having a nominal value for the correlated parameter, a second sub-target having a value less than the nominal value for the correlated parameter and a third sub-target having a value greater than the nominal value for the correlated parameter.
46. A computer program comprising program instructions operable to perform the method of any of clauses 1 to 40, when run on a suitable apparatus.
47. A non-transient computer program carrier comprising the computer program of clause 46.
48. A processing arrangement comprising:
   the non-transient computer program carrier of clause 47; and
   a processor operable to run the computer program comprised on the non-transient computer program carrier.
49. A metrology apparatus comprising the processing arrangement of clause 48.
50. A lithography cell comprising a lithography apparatus and the metrology apparatus, comprising the processing arrangement of clause 48.

0081 The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

0082 The term "lens", where the context allows, may refer to any one or combination of various types of optical components, including refractive, reflective, magnetic, electromagnetic and electrostatic optical components.

0083 The term target should not be construed to mean only dedicated targets formed for the specific purpose of metrology. The term target should be understood to encompass other structures, including product structures, which have properties suitable for metrology applications.

0084 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

0085 The breadth and scope of the present invention should not be limited by any of the above-described exemplary embodiments, but should be defined only in accordance with the following claims and their equivalents.

## Claims

1. A method of determining at least one vertical parameter of interest relating to a structure of interest on a substrate comprising:
obtaining first metrology data and/or data derived therefrom, the first metrology data relating to a measurement of the structure of interest when not comprising a layer of interest to which the vertical parameter of interest relates, or a representative structure being representative of the structure of interest when not comprising the layer of interest;
obtaining second metrology data relating to a measurement of the structure of interest when comprising the layer of interest;
removing the first metrology data and/or data derived therefrom from the second metrology data to obtain residual metrology data;
obtaining at least one model to relate the residual metrology data to the vertical parameter of interest; and
using the model to derive the vertical parameter of interest from the residual metrology data.

2. A method according to claim 1, wherein the model is a trained model.

3. A method according to claim 1 or 2, wherein the first metrology data and/or data derived therefrom comprises dominant mode data derived from the first metrology data.

4. A method according to claim 3, wherein at least some of the dominant mode data comprises training dominant mode data derived from the first metrology data having been measured in a training phase on partial training structure, the partial training structure being at least representative of the structure of interest when not comprising the layer of interest.

5. A method according to claim 3 or 4, comprising obtaining and/or determining updated dominant mode data having been measured on the structure of interest when not comprising the layer of interest; comparing the updated dominant mode data to the previous dominant mode data; and
deciding whether to perform an update action based on the comparison.

6. A method according to any preceding claim, wherein the vertical parameter of interest comprises a dimensional parameter in a direction perpendicular to a substrate plane defined by the substrate.

7. A method according to any preceding claim, wherein the vertical parameter of interest comprises at least one of etch depth, gate height, silicon fin height, any electrode height, thickness of the layer of interest, dielectric thickness, height of a metal line.

8. A method according to any preceding claim, wherein the structure of interest comprises a functional product structure.

9. A method according to any preceding claim, comprising performing an initial training phase to train the model to obtain the trained model, the method comprising:
obtaining first training metrology data and/or data derived therefrom, the first training metrology data relating to a measurement of a plurality of partial training structures, the partial training structures being at least representative of the structure of interest when not comprising the layer of interest;
obtaining second training metrology data relating to a measurement of training structures, the training structures comprising the partial training structures when comprising the layer of interest;
removing the first training metrology data and/or data derived therefrom from the second training metrology data to obtain residual training metrology data; and
training the model to relate the residual training metrology data to the vertical parameter of interest using the residual training metrology data and ground truth data for the vertical parameter of interest.

10. A method according to any preceding claim, wherein at least the second metrology data comprises processed data comprising only a symmetrical component of the second metrology data.

11. A method according to any preceding claim, wherein at least some of the first metrology data comprises training first metrology data having been measured in a training phase on partial training structure, the partial training structure being at least representative of the structure of interest when not comprising the layer of interest.

12. A substrate comprising:
a plurality of training targets, each training target comprising a plurality of sub-targets, wherein a correlated parameter is varied over the plurality of sub-targets, the correlated parameter being correlated with a vertical parameter of interest of the training target, the training target being representative of a structure of interest;
wherein all layers of the training targets which affect the vertical parameter interest and which are below the layer of interest, have been exposed and processed similarly to the structure of interest.

13. A computer program comprising program instructions operable to perform the method of any of claims 1 to 11, when run on a suitable apparatus.

14. A non-transient computer program carrier comprising the computer program of claim 13.

15. A processing arrangement comprising:
the non-transient computer program carrier of claim 14; and
a processor operable to run the computer program comprised on the non-transient computer program carrier.
